# EUROPEAN PATENT APPLICATION

(11) **EP 3 923 073 A1**
(43) Date of publication of application: **15.12.2021**
(21) Application number: 21177869.1
(22) Date of filing: 04.06.2021
(51) Int. Cl.: G03F 7/00, G03F 7/004, G03F 7/027

(54) **PHOTOCURABLE COMPOSITION AND PATTERN FORMING METHOD**

(30) Priority: 10.06.2020 JP 2020100640
(71) Applicant: TOKYO OHKA KOGYO CO., LTD., Kawasaki-shi, Kanagawa 211 0012 (JP)
(72) Inventor: KONNO, Kenri, KANAGAWA, 211-0012 (JP)
(74) Representative: Plasseraud IP

(57) **Abstract**

Provided is a photocurable composition including metal oxide nanoparticles having an average primary particle diameter of 50 nm or less as a component (X), phosphoric acid (meth)acrylate as a component (P), and a photopolymerization initiator as a component (C).

## Description

### BACKGROUND OF THE INVENTION

### Field of the Invention

The present invention relates to a photocurable compositions and a pattern forming method.

Priority is claimed on Japanese Patent Application No. 2020-100640, filed on June 10, 2020, the content of which is incorporated herein by reference.

### Description of Related Art

A lithography technology is a core technology in the process of manufacturing semiconductor devices, and with the recent increase in the integration of semiconductor integrated circuits (IC), further miniaturization of wiring is progressing. Typical examples of the miniaturization method include shortening the wavelength of a light source using a light source having a shorter wavelength such as a KrF excimer laser, an ArF excimer laser, an F2 laser, extreme ultraviolet light (EUV), an electron beam (EB), or an X-ray, and increasing the diameter (increase in NA) of the numerical aperture (NA) of a lens of an exposure device.

Under such-described circumstances, nanoimprint lithography, which is a method of pressing a mold having a predetermined pattern against a resin film formed on a substrate so that the pattern of the mold is transferred to the resin film, is expected as a fine pattern forming method for a semiconductor from the viewpoint of the productivity.

In the nanoimprint lithography, a photocurable composition containing a photocurable resin that is cured by light (ultraviolet rays or electron beams) is used. In such a case, a transfer pattern (structure) is obtained by pressing a mold having a predetermined pattern against a resin film containing a photocurable resin, irradiating the resin film with light to cure the photocurable resin, and peeling the mold off from the resin cured film.

The photocurable composition used for nanoimprint lithography is required to have properties such as coatability in a case where a substrate is coated with the composition through spin coating or the like; and curability in a case where the composition is heated or exposed. In a case where the coatability thereof on the substrate is poor, the film thickness of the photocurable composition applied onto the substrate is uneven, and the pattern transferability is likely to be degraded in a case where the mold is pressed against the resin film. Further, the curability is an important property for maintaining the pattern formed by pressing the mold to have desired dimensions. Further, the photocurable composition is also required to have satisfactory mold releasability in a case where the mold is peeled off from the resin cured film.

For example, Japanese Unexamined Patent Application, First Publication No. 2016-207685 discloses a nanoimprint composition containing a siloxane polymer that contains a polymerizable group polymerized by irradiation with light. With the composition, the mold releasability can be improved.

### Citation List

### Patent Literature

[PTL 1] Japanese Unexamined Patent Application, First Publication No. 2016-207685

### SUMMARY OF THE INVENTION

In recent years, it has been examined to apply nanoimprint lithography for enhancing the functionality of 3D sensors for autonomous driving and AR waveguides for AR (augmented reality) glasses. In the 3D sensors and AR glasses, it is required to increase the refractive index of a permanent film material constituting a part of the device. It is known to add metal oxide nanoparticles as one means for increasing the refractive index of a nanoimprint material.

As a result of examination conducted by the present inventors, it was found that the dispersibility of the metal oxide nanoparticles and the photocurable resin in the nanoimprint material greatly affects the optical properties such as the haze or the transparency of the cured film. Further, it was also found that aggregation of primary particles of the metal oxide nanoparticles is a factor for the dispersibility of the metal oxide nanoparticles and the curable resin. Meanwhile, it was found that in a case where the metal oxide nanoparticles are subjected to a surface treatment in order to improve the dispersibility of the metal oxide nanoparticles, the balance of the dispersibility is worse because the particles are mixed with the photocurable resin.

The present invention has been made in consideration of the above-described circumstances, and an object thereof is to provide a photocurable composition with satisfactory dispersibility and optical properties, and a pattern forming method.

In order to solve the above-described problems, the present invention has adopted the following configurations.

That is, according to a first aspect of the present invention, there is provided a photocurable composition including: metal oxide nanoparticles having an average primary particle diameter of 50 nm or less as a component (X); phosphoric acid (meth)acrylate as a component (P); and a photopolymerization initiator as a component (C).

According to a second aspect of the present invention, there is provided a pattern forming method including: a step of forming a resin film using the photocurable composition according to the first aspect of the present invention on a substrate; a step of pressing a mold having an uneven pattern against the resin film to transfer the uneven pattern to the resin film; a step of exposing the resin film to which the uneven pattern is transferred while pressing the mold against the resin film to form a resin cured film; and a step of peeling the mold off from the resin cured film.

According to the present invention, it is possible to provide a photocurable composition with satisfactory dispersibility and optical properties, and a pattern forming method.

### BRIEF DESCRIPTION OF THE DRAWINGS

FIGS. 1(A) to 1(D) are schematic step views for describing an embodiment of a nanoimprint pattern forming method.
FIGS. 2(E) and 2(F) are schematic step views for describing an example of an optional step.

### DETAILED DESCRIPTION OF THE INVENTION

In the present description and the scope of the present patent claims, the term "aliphatic" is a relative concept used in relation to the term "aromatic", and defines a group or compound that has no aromaticity.

The term "alkyl group" includes a linear, branched, or cyclic monovalent saturated hydrocarbon group unless otherwise specified. The same applies to the alkyl group in an alkoxy group.

The term "alkylene group" includes a linear, branched, or cyclic divalent saturated hydrocarbon group unless otherwise specified.

The "halogenated alkyl group" is a group in which some or all hydrogen atoms of an alkyl group have been substituted with halogen atoms. Examples of the halogen atom include a fluorine atom, a chlorine atom, a bromine atom, and an iodine atom.

The "fluorinated alkyl group" or a "fluorinated alkylene group" is a group in which some or all hydrogen atoms of an alkyl group or an alkylene group have been substituted with fluorine atoms.

The term "constitutional unit" indicates a monomer unit (monomeric unit) constituting a polymer compound (a resin, a polymer, or a copolymer).

The "(meth)acrylate" indicates at least one of acrylate and methacrylate.

The expression "may have a substituent" includes both a case where a hydrogen atom (-H) is substituted with a monovalent group and a case where a methylene (-CH2-) group is substituted with a divalent group.

The term "light exposure" is a general concept for irradiation with radiation.

The "constitutional unit derived from acrylic acid ester" indicates a constitutional unit that is formed by cleavage of an ethylenic double bond of acrylic acid ester.

The "acrylic acid ester" indicates a compound in which a hydrogen atom at the terminal of the carboxy group of acrylic acid (CH₂=CH-COOH) has been substituted with an organic group.

In the acrylic acid ester, the hydrogen atom bonded to the carbon atom at the α-position may be substituted with a substituent. The substituent (R^{α0}) that substitutes the hydrogen atom bonded to the carbon atom at the α-position is a group or an atom other than a hydrogen atom, and examples thereof include an alkyl group having 1 to 5 carbon atoms and a halogenated alkyl group having 1 to 5 carbon atoms. Further, itaconic acid diester in which the substituent (R^{α0}) has been substituted with a substituent having an ester bond or α-hydroxyacryl ester in which the substituent (R^{α0}) has been substituted with a hydroxyalkyl group or a group obtained by modifying a hydroxyl group thereof can be exemplified as acrylic acid ester. Further, the carbon atom at the α-position of acrylic acid ester indicates the carbon atom to which the carbonyl group of acrylic acid is bonded, unless otherwise specified.

Hereinafter, acrylic acid ester in which the hydrogen atom bonded to the carbon atom at the α-position has been substituted with a substituent is also referred to as α-substituted acrylic acid ester. Further, acrylic acid ester and α-substituted acrylic acid ester are also collectively referred to as "(α-substituted) acrylic acid ester". Hereinafter, acrylic acid in which the hydrogen atom bonded to the carbon atom at the α-position has been substituted with a substituent is also referred to as α-substituted acrylic acid. Further, acrylic acid and α-substituted acrylic acid are also collectively referred to as "(α-substituted) acrylic acid".

As the alkyl group as the substituent at the α-position, a linear or branched alkyl group is preferable, and specific examples thereof include alkyl groups of 1 to 5 carbon atoms (such as a methyl group, an ethyl group, a propyl group, an isopropyl group, an n-butyl group, an isobutyl group, a tert-butyl group, a pentyl group, an isopentyl group, and a neopentyl group).

Specific examples of the halogenated alkyl group as the substituent at the α-position include groups in which some or all hydrogen atoms in the above-described "alkyl group as the substituent at the α-position" have been substituted with halogen atoms. Examples of the halogen atom include a fluorine atom, a chlorine atom, a bromine atom, and an iodine atom. Among these, a fluorine atom is particularly preferable.

Specific examples of the hydroxyalkyl group as the substituent at the α-position include groups in which some or all hydrogen atoms in the above-described "alkyl group as the substituent at the α-position" have been substituted with a hydroxyl group. The number of hydroxyl groups in the hydroxyalkyl group is preferably in a range of 1 to 5 and most preferably 1.

In the present specification and the scope of the appended claims of the present patent, asymmetric carbons may be present and enantiomers or diastereomers may be present depending on the structures of the chemical formulae. In such a case, these isomers are represented by one formula. These isomers may be used alone or in the form of a mixture.

### (Photocurable composition)

A photocurable composition according to a first embodiment of the present invention contains metal oxide nanoparticles having an average primary particle diameter of 50 nm or less as a component (X), phosphoric acid (meth)acrylate as a component (P), and a photopolymerization initiator as a component (C).

### <Component (X)>

The component (X) is metal oxide nanoparticles having an average primary particle diameter of 50 nm or less.

The average primary particle diameter of the component (X) is preferably in a range of 0.1 to 45 nm and more preferably in a range of 1 to 40 nm. In a case where the upper limit of the average primary particle diameter of the component (X) is in the above-described range, satisfactory dispersibility can be exhibited in the photocurable composition.

In the present embodiment, the average primary particle diameter is a value measured by a dynamic light scattering method.

The component (X) is not particularly limited as long as the average primary particle diameter thereof is 50 nm or less, and examples of the component (X) include oxide particles such as titanium (Ti), zirconium (Zr), aluminum (Al), silicon (Si), zinc (Zn), and magnesium (Mg). Among these, from the viewpoint of the dispersibility, titania nanoparticles or zirconia nanoparticles are preferable as the component (X).

In the present embodiment, commercially available products of metal oxide nanoparticles can be used as the component (X).

Examples of titania nanoparticles include TTO Series (TTO-51 (A), TTO-51 (C), and the like), TTO-S, and V Series (TTO-S-1, TTO-S-2, TTO-V-3, and the like) (all manufactured by Ishihara Sangyo Kaisha, Ltd.); MT Series (MT-01, MT-05, MT-100SA, MT-500SA, and the like) (all manufactured by Tayca Corporation); and STR-100A-LP and the like (manufactured by Sakai Chemical Industry Co., Ltd.).

As zirconia nanoparticles, commercially available products of zirconium dioxide particles can be used, and examples thereof include UEP (manufactured by Daiichi Kisenso Kagaku-Kogyo Co., Ltd.), PCS (manufactured by Nippon Denko Co., Ltd.), JS-01, JS-03, JS-04 (manufactured by Nippon Denko Co., Ltd.), and UEP-100 (manufactured by Daiichi Kisenso Kagaku-Kogyo Co., Ltd.).

In the photocurable composition according to the present embodiment, the component (X) may be used alone or in combination of two or more kinds thereof.

The content of the component (X) is preferably in a range of 10 to 99 parts by mass, more preferably in a range of 20 to 95 parts by mass, and still more preferably in a range of 30 to 95 parts by mass with respect to 100 parts by mass which is the total amount of the component (X), the following component (P), and the following component (B).

In a case where the content of the component (X) is greater than or equal to the lower limit of the above-described preferable range, the optical properties of the resin cured film formed of the photocurable composition are more satisfactory. Further, in a case where the content of the component (X) is less than or equal to the upper limit of the above-described preferable range, the filling property of the photocurable composition into the mold is improved.

### <Component (P)>

The component (P) is phosphoric acid (meth)acrylate.

In the present embodiment, the weight-average molecular weight of the component (P) is preferably 300 or less. In a case where the weight-average molecular weight of the component (P) is less than or equal to the upper limit of the above-described preferable range, the filling property of the photocurable composition into a mold is improved.

Examples of the component (P) include a (meth)acrylate monomer having phosphoric acid ester. Examples of the phosphoric acid ester include alkyl phosphoric acid ester, alkylene glycol phosphoric acid ester, and fatty acid phosphoric acid ester.

Preferred examples of the component (P) include those containing phosphoric acid ester represented by Formula (P1).

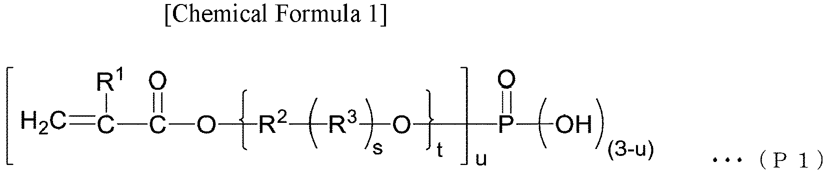

[In the formula, R¹ represents a hydrogen atom or a methyl group. R² represents a linear or branched alkylene group having 1 to 4 carbon atoms. R³ represents a divalent organic group. s represents an integer of 1 to 3. t represents an integer of 1 to 6. u represents 1 or 2.]

In the formula (PI), R² represents a linear or branched alkylene group having 1 to 4 carbon atoms and preferably a linear or branched alkylene group having 2 or 3 carbon atoms.

In Formula (PI), R³ represents a divalent organic group. Examples of the divalent organic group as R³ include a divalent hydrocarbon group which may have a substituent and a divalent linking group having a heteroatom.

In a case where R³ represents a divalent hydrocarbon group which may have a substituent, the hydrocarbon group may be an aliphatic hydrocarbon group or an aromatic hydrocarbon group, and is preferably an aliphatic hydrocarbon group. The number of carbon atoms of the hydrocarbon group is preferably in a range of 1 to 12, more preferably in a range of 2 to 10, and still more preferably in a range of 2 to 6.

The aliphatic hydrocarbon group as R³ may be saturated or unsaturated. In general, it is preferable that the aliphatic hydrocarbon group is saturated. Further, examples of the aliphatic hydrocarbon group as R³ include a linear or branched aliphatic hydrocarbon group. Among the examples, a linear aliphatic hydrocarbon group is preferable.

As the linear aliphatic hydrocarbon group as R³, a linear alkylene group is preferable. Specific examples thereof include a methylene group [-CH2-], an ethylene group [-(CH₂)₂-], a trimethylene group [-(CH2)3-], a tetramethylene group [-(CH2)4-], and a pentamethylene group [-(CH₂)₅-].

As the branched aliphatic hydrocarbon group as R³, a branched alkylene group is preferable, and specific examples thereof include alkylalkylene groups, for example, alkylmethylene groups such as -CH(CH3)-, -CH(CH2CH3)-, -C(CH3)2-, - C(CH3)(CH2CH3)-, -C(CH3)(CH2CH2CH3)-, and -C(CH2CH3)2-; alkylethylene groups such as -CH(CH₃)CH₂-, -CH(CH₃)CH(CH₃)-, -C(CH₃)₂CH₂-, -CH(CH₂CH₃)CH₂-, and - C(CH₂CH₃)₂-CH₂-; alkyltrimethylene groups such as -CH(CH₃)CH₂CH₂- and - CH₂CH(CH₃)CH₂-; and alkyltetramethylene groups such as -CH(CH₃)CH₂CH₂CH₂- and -CH₂CH(CH₃)CH₂CH₂-.

The linear or branched aliphatic hydrocarbon group may or may not have a substituent. Examples of the substituent include a fluorine atom, a fluorinated alkyl group having 1 to 5 carbon atoms which has been substituted with a fluorine atom, and a carbonyl group.

In a case where R³ represents a divalent linking group having a heteroatom, preferred examples of the linking group include -O-, -C(=O)-O-, -O-C(=O)-, -C(=O)-, -O-C(=O)-O-, -C(=O)-NH-, -NH-, -S-, -S(=O)₂-, and -S(=O)₂-O-. Among these, -O-, -C(=O)-O-, or -O-C(=O)- is preferable.

Among the examples described above, it is preferable that R³ represents a linear or branched alkylene group, an ester bond [-C(=O)-O- or -O-C(=O)-], an ether bond (-O-), or a combination thereof.

In Formula (P1), s represents an integer of 0 to 3 and preferably 0 or 1.

t represents an integer of 1 to 6, preferably an integer of 1 to 3, and more preferably 1 or 2.

u represents 1 or 2.

Specific examples of the phosphoric acid ester represented by Formula (P1) are shown below. In the chemical formula, R¹ represents a hydrogen atom or a methyl group. u represents 1 or 2.

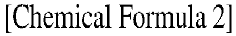

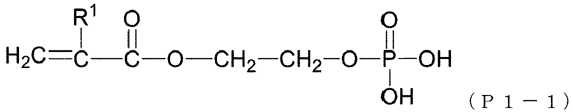

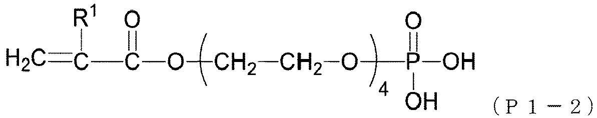

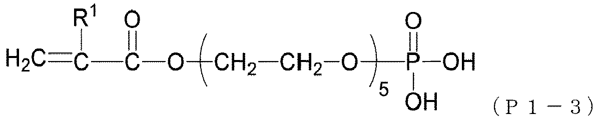

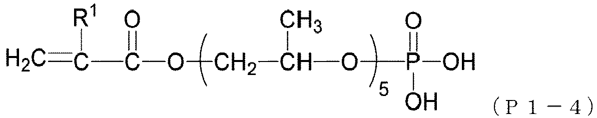

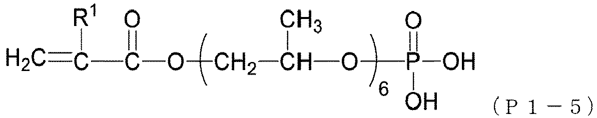

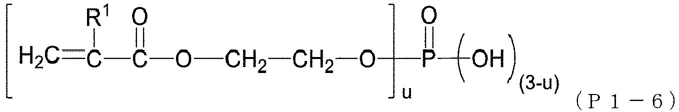

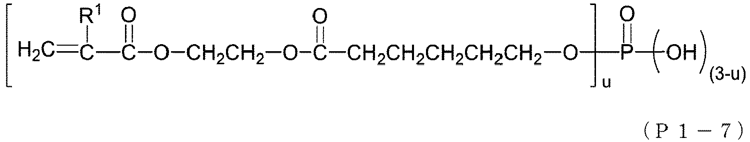

As the component (P), a commercially available product can be obtained and used.

Examples of the commercially available product of the component (P) include "KAYAMER PM-21" (product name, manufactured by Nippon Kayaku Co., Ltd.) in which s represents 1, t represents 1, and u represents 1.5 in Formula (P1); "KAYAMER PM-2" (product name, manufactured by Nippon Kayaku Co., Ltd.) in which s represents 0, t represents 1, and u represents 1.5 in Formula (P1); "PHOSMER M" (product name, manufactured by Unichemical Co., Ltd.) in which s represents 0, t represents 1, and u represents 1 in Formula (PI); "PHOSMER PE" (product name, manufactured by Unichemical Co., Ltd.) in which s represents 0, t represents 4 or 5, and u represents 1 in Formula (PI); and "PHOSMER PP" (product name, manufactured by Unichemical Co., Ltd.) in which s represents 0, t represents 5 or 6, and u represents 1 in Formula (P1).

In the photocurable composition according to the present embodiment, the component (P) may be used alone or in combination of two or more kinds thereof.

The content of the component (P) is preferably in a range of 1 to 50 parts by mass, more preferably in a range of 2 to 45 parts by mass, and still more preferably in a range of 3 to 40 parts by mass with respect to 100 parts by mass which is the total amount of the above-described component (X), the above-described component (P), and the following component (B).

In a case where the content of the component (P) is greater than or equal to the lower limit of the above-mentioned preferable range, the dispersibility of the component (X) in the photocurable composition is more satisfactory. Further, in a case where the content of the component (P) is less than or equal to the upper limit of the above-described preferable range, the optical properties of the resin cured film formed of the photocurable composition are more satisfactory.

In the present embodiment, the ratio of the amount of the component (X) to the total amount of the component (X) and the component (P) is preferably in a range of 0.40 to 0.97, more preferably in a range of 0.50 to 0.95, and still more preferably in a range of 0.60 to 0.90.

In a case where the ratio of the amount of the component (X) is not greater than or equal to the lower limit of the above-described preferable range, the optical properties of the resin cured film formed of the photocurable composition are more satisfactory. Further, in a case where the ratio of the amount of the component (X) is less than or equal to the upper limit of the above-described preferable range, the filling property of the photocurable composition into the mold is improved.

### <Component (C)>

The component (C) is a photopolymerization initiator.

As the component (C), a compound that initiates polymerization of the component (P) upon exposure or promotes the polymerization is used.

Examples of the component (C) include 1-hydroxycyclohexylphenyl ketone, 2-hydroxy-2-methyl-1-phenylpropan-1-one, 1-[4-(2-hydroxyethoxy)phenyl] -2-hydroxy-2-methyl-1-propan-1-one, 1-(4-isopropylphenyl)-2-hydroxy-2-methylpropan-1-one, 1- (4-dodecylphenyl) -2-hydroxy-2-methylpropan-1-one, 2,2-dimethoxy-1,2-diphenylethan-1-one, bis(4-dimethylaminophenyl)ketone, 2-methyl-1-(4-methylthiophenyl)-2-morpholinopropan-1-one, 2-benzyl-2-dimethylamino-1-(4-morpholinophenyl)-butanon-1, ethanone-1-[9-ethyl-6-(2-methylbenzoyl)-9H-carbazol-3-yl]-1-(o-acetyloxime), bis(2,4,6-trimethylbenzoyl)-phenylphosphine oxide, 4-benzoyl-4'-methyldimethylsulfide, 4-dimethylaminobenzoic acid, methyl 4-dimethylaminobenzoate, ethyl 4-dimethylaminobenzoate, butyl 4-dimethylaminobenzoate, 4-dimethylamino-2-ethylhexylbenzoic acid, 4-dimethylamino-2-isoamylbenzoic acid, benzyl-β-methenylethyl acetal, benzyl dimethyl ketal, 1-phenyl-1,2-propanedion-2-(o-ethoxycarbonyl)oxime, methyl o-benzoyl benzoate, 2,4-diethylthioxanthone, 2-chlorothioxanthone, 2,4-dimethylthioxanthone, 1-chloro-4-propoxythioxanthone, thioxanthene, 2-chlorothioxanthene, 2,4-diethylthioxanthene, 2-methylthioxanthene, 2-isopropylthioxanthene, 2-ethylanthraquinone, octamethyl anthraquinone, 1,2-benzanthraquinone, 2,3-diphenylanthraquinone, azobisisobutyronitrile, benzoyl peroxide, cumeme peroxide, 2-mercaptobenzoimidal, 2-mercaptobenzoxazole, 2-mercaptobenzothiazole, a 2-(o-chlorophenyl)-4,5-di(m-methoxyphenyl)-imidazolyl dimer, benzophenone, 2-chlorobenzophenone, p,p'-bisdimethylaminobenzophenone, 4,4'-bisdiethylaminobenzophenone, 4,4'-dichlorobenzophenone, 3,3-dimethyl-4-methoxybenzophenone, benzoyl, benzoin, benzoin methyl ether, benzoin ethyl ether, benzoin isopropyl ether, benzoin-n-butyl ether, benzoin isobutyl ether, benzoin butyl ether, acetophenone, 2,2-diethoxyacetophenone, p-dimethylacetophenone, p-dimethylaminopropiophenone, dichloroacetophenone, trichloroacetophenone, p-tert-butylacetophenone, p-dimethylaminoacetophenone, p-tert-butyltrichloroacetophenone, p-tert-butyldichloroacetophenone, α,α-dichloro-4-phenoxyacetophenone, thioxanthone, 2-methylthioxanthone, 2-isopropylthioxanthone, dibenzosuberone, pentyl-4-dimethylaminobenzoate, 9-phenylacridine, 1,7-bis-(9-acridinyl)heptane, 1,5-bis-(9-acridinyl)pentane, 1,3-bis-(9-acridinyl)propane, p-methoxytriazine, 2,4,6-tris(trichloromethyl)-s-triazine, 2-methyl-4,6-bis(trichloromethyl)-s-triazine, 2-[2-(5-methylfuran-2-yl)ethenyl]-4,6-bis(trichloromethyl)-s-triazine, 2-[2-(fran-2-yl)ethenyl]-4,6-bis (trichloromethyl)-s-triazine, 2-[2-(4-diethylamino-2-methylphenyl)ethenyl]-4,6-bis(trichloromethyl)-s-triazine, 2-[2-(3,4-dimethoxyphenyl)ethenyl]-4,6-bis(trichloromethyl)-s-triazine, 2-(4-methoxyphenyl)-4,6-bis(trichloromethyl)-s-triazine, 2-(4-ethoxystyryl)-4,6-bis (trichloromethyl)-s-triazine, 2-(4-n-butoxyphenyl)-4,6-bis(trichloromethyl)-s-triazine, 2,4-bis-trichloromethyl-6-(3-bromo-4-methoxy)phenyl-s-triazine, 2,4-bis-trichloromethyl-6-(2-bromo-4-methoxy)phenyl-s-triazine, 2,4-bistrichloromethyl-6-(3-bromo-4-methoxy)styrylphenyl-s-triazine, 2,4-bis-trichloromethyl-6-(2-bromo-4-methoxy)styrylphenyl-s-triazine; ketone peroxides such as methyl ethyl ketone peroxide, methyl isobutyl ketone peroxide, and cyclohexanone peroxide; diacyl peroxides such as isobutylyl peroxide and bis(3,5,5-trimethylhexanoyl)peroxide; hydroperoxides such as p-menthanehydroperoxide and 1,1,3,3-tetramethylbutylhydroperoxide; dialkyl peroxides such as 2,5-dimethyl-2,5-bis(t-butylperoxy)hexane; peroxy ketals such as 1,1-bis(t-butylperoxy)-3,3,5-trimethylcyclohexane; peroxy esters such as t-butylperoxyneodecanoate and 1,1,3,3-tetramethylperoxyneodecanoate; peroxydicarbonates such as di-n-propyl peroxydicarbonate and diisopropyl peroxydicarbonate; and azo compounds such as azobisisobutyronitrile, 2,2'-azobis(2,4-dimethylvaleronitrile), and 2,2'-azobisisobutyrate.

Among these, 2-methyl-1-(4-methylthiophenyl)-2-morpholinopropan-1-one, 2-benzyl-2-dimethylamino-1-(4-morpholinophenyl)-butanone-1, and bis(2,4,6-trimethylbenzoyl)-phenylphosphine oxide are preferable.

As the component (C), a commercially available product can be obtained and used.

Examples of the commercially available product of the component (C) include "IRGACURE 907" (product name, manufactured by BASF SE), "IRGACURE 369" (product name, manufactured by BASF SE), "IRGACURE 819" (product name, manufactured by BASF SE), and "Omnirad 184" (product name, manufactured by IGM Resins B. V.).

In the photocurable composition according to the embodiment, the component (C) may be used alone or in combination of two or more kinds thereof. Among these, as the component (C), a combination of at least one of 2-methyl-1-(4-methylthiophenyl)-2-morpholinopropan-1-one and 2-benzyl-2-dimethylamino-1-(4-morpholinophenyl)-butanon-1 with bis(2,4,6-trimethylbenzoyl)-phenylphosphine oxide is particularly preferable.

The content of the component (C) is preferably in a range of 1 to 20 parts by mass, more preferably in a range of 2 to 15 parts by mass, and still more preferably in a rang of 5 to 15 parts by mass with respect to 100 parts by mass which is the total amount of the above-described component (X), the above-described component (P), and the following component (B). In a case where the content of the component (C) is in the above-described preferable range, the photocurability is further improved.

### <Optional components >

The photocurable composition according to the embodiment may contain a photopolymerizable monomer, as a component (B), containing one or two polymerizable functional groups as desired (here, the component (P) is excluded); and a miscible additive, for example, an additive for improving the properties of the resin film, in addition to the component (X), the component (P), and the component (C).

### <Component (B)>

The component (B) is a photopolymerizable monomer containing a polymerizable functional group (here, the component (P) is excluded).

The "polymerizable functional group" is a group which is capable of polymerizing compounds through radical polymerization or the like and has multiple bonds between carbon atoms such as an ethylenic double bond.

Examples of the polymerizable functional group include a vinyl group, an allyl group, an acryloyl group, a methacryloyl group, a fluorovinyl group, a difluorovinyl group, a trifluorovinyl group, a difluorotrifluoromethylvinyl group, a trifluoroallyl group, a perfluoroallyl group, a trifluoromethylacryloyl group, a nonylfluorobutylacryloyl group, a vinyl ether group, a fluorine-containing vinyl ether group, an allyl ether group, a fluorine-containing allyl ether group, a styryl group, a vinylnaphthyl group, a fluorine-containing styryl group, a fluorine-containing vinylnaphthyl group, a norbornyl group, a fluorine-containing norbornyl group, and a silyl group. Among these, a vinyl group, an allyl group, an acryloyl group, or a methacryloyl group is preferable, and an acryloyl group or a methacryloyl group is more preferable.

Examples of the photopolymerizable monomer (monofunctional monomer) containing one polymerizable functional group include a (meth)acrylate having an aliphatic polycyclic structure (hereinafter, referred to as a "component (B1)") such as isobornyl (meth)acrylate, 1-adamantyl (meth)acrylate, 2-methyl-2-adamantyl (meth)acrylate, 2-ethyl-2-adamantyl (meth)acrylate, bornyl (meth)acrylate, or tricyclodecanyl (meth)acrylate; a (meth)acrylate having an aliphatic monocyclic structure such as dicyclopentanyl (meth)acrylate, dicyclopentenyl (meth)acrylate, cyclohexyl (meth)acrylate, 4-butylcyclohexyl (meth)acrylate, or acryloylmorpholin; a (meth)acrylate having a chain structure such as 2-hydroxyethyl (meth)acrylate, 2-hydroxypropyl (meth)acrylate, 2-hydroxybutyl (meth)acrylate, methyl (meth)acrylate, ethyl (meth)acrylate, propyl (meth)acrylate, isopropyl (meth)acrylate, butyl (meth)acrylate, amyl (meth)acrylate, isobutyl (meth)acrylate, t-butyl (meth)acrylate, pentyl (meth)acrylate, isoamyl (meth)acrylate, hexyl (meth)acrylate, heptyl (meth)acrylate, octyl (meth)acrylate, isooctyl (meth)acrylate, 2-ethylhexyl (meth)acrylate, nonyl (meth)acrylate, decyl (meth)acrylate, isodecyl (meth)acrylate, undecyl (meth)acrylate, dodecyl (meth)acrylate, lauryl (meth)acrylate, stearyl (meth) acrylate, or isostearyl (meth) acrylate; a (meth)acrylate having an aromatic ring structure (hereinafter, referred to as a component (B2)") such as benzyl (meth)acrylate, phenoxyethyl (meth)acrylate, phenoxy-2-methylethyl (meth)acrylate, phenoxyethoxyethyl (meth)acrylate, 3-phenoxy-2-hydroxypropyl (meth)acrylate, 2-phenylphenoxyethyl (meth)acrylate, 4-phenylphenoxyethyl (meth)acrylate, 3-(2-phenylphenyl)-2-hydroxypropyl (meth)acrylate, EO-modified p-cumylphenol (meth)acrylate, 2-bromophenoxyethyl (meth)acrylate, 2,4-dibromophenoxyethyl (meth)acrylate, 2,4,6-tribromophenoxyethyl (meth)acrylate, EO-modified phenoxy (meth)acrylate, PO-modified phenoxy (meth)acrylate, or polyoxyethylene nonylphenyl ether (meth)acrylate; tetrahydrofurfuryl (meth)acrylate, butoxyethyl (meth)acrylate, ethoxydiethylene glycol (meth)acrylate, polyethylene glycol mono(meth)acrylate, polypropylene glycol mono(meth)acrylate, methoxyethylene glycol(meth)acrylate, ethoxyethyl (meth)acrylate, methoxypolyethylene glycol (meth)acrylate, methoxypolypropylene glycol (meth)acrylate; diacetone (meth)acrylamide, isobutoxymethyl (meth)acrylamide, N,N-dimethyl (meth)acrylamide, t-octyl (meth)acrylamide, dimethylaminoethyl (meth)acrylate, diethylaminoethyl (meth)acrylate, 7-amino-3,7-dimethyloctyl (meth)acrylate, N,N-diethyl (meth)acrylamide, N,N-dimethylaminopropyl (meth)acrylamide; and an one-terminal methacrylsiloxane monomer.

Examples of the commercially available product of the monofunctional monomer include ARONIX M101, M102, M110, M111, M113, M117, M5700, TO-1317, M120, M150, and M156 (all manufactured by Toagosei Co., Ltd.); MEDOL10, MIBDOL10, CHDOL10, MMDOL30, MEDOL30, MIBDOL30, CHDOL30, LA, IBXA, 2-MTA, HPA, VISCOAT #150, #155, #158, #190, #192, #193, #220, #2000, #2100, and #2150 (all manufactured by Osaka Organic Chemical Industry Ltd.); light acrylate BO-A, EC-A, DMP-A, THF-A, HOP-A, HOA-MPE, HOA-MPL, HOA (N), PO-A, P-200A, NP-4EA, NP-8EA, IB-XA, and Epoxy Ester M-600A (all manufactured by Kyoeisha Chemical Co., Ltd.); KAYARAD TC110S, R-564, and R-128H (all manufactured by Nippon Kayaku Co., Ltd.); NK ester AMP-10G and AMP-20G (both manufactured by Shin-Nakamura Chemical Industry Co., Ltd.); FA-511A, FA-512A, FA-513A, and FA-BZA (all manufactured by Hitachi Chemical Co., Ltd.); PHE, CEA, PHE-2, PHE-4, BR-31, BR-31M, and BR-32 (all manufactured by DKS Co., Ltd.); VP (manufactured by BASF SE); ACMO, DMAA, and DMAPAA (all manufactured by Kohjin); and X-22-2404 (manufactured by Shin-Etsu Chemical Co., Ltd.).

Examples of the photopolymerizable monomer containing two polymerizable functional group (bifunctional monomer) include trimethylolpropane di(meth)acrylate, ethylene glycol di(meth)acrylate, tetraethylene glycol di(meth)acrylate, polyethylene glycol di(meth)acrylate, polypropylene glycol di(meth)acrylate, 1,4-butanediol di(meth)acrylate, 1,6-hexanediol di(meth)acrylate, neopentyl glycol di(meth)acrylate, and bis(hydroxylmethyl) tricyclodecane di(meth)acrylate.

Examples of the commercially available product of the bifunctional monomer include light acrylates 3EG-A, 4EG-A, 9EG-A, NP-A, DCP-A, BP-4EAL, and BP-4PA (all manufactured by Kyoeisha Chemical Co., Ltd.).

Examples of the photopolymerizable compound containing three or more polymerizable functional groups include a photopolymerizable siloxane compound, a photopolymerizable silsesquioxane compound, and a polyfunctional monomer containing three or more polymerizable functional groups.

Examples of the photopolymerizable siloxane compound include a compound containing an alkoxysilyl group and a polymerizable functional group in a molecule.

Examples of the commercially available product of the photopolymerizable siloxane compound include "KR-513", "X-40-9296", "KR-511", "X-12-1048", and "X-12-1050" (product names, all manufactured by Shin-Etsu Chemical Co., Ltd.).

Examples of the photopolymerizable silsesquioxane compound include a compound which has a main chain skeleton formed of a Si-O bond and is represented by the following chemical formula: [(RSiO_{3/2})ₙ] (in the formula, R represents an organic group and n represents a natural number).

R represents a monovalent organic group, and examples of the monovalent organic group include a monovalent hydrocarbon group which may have a substituent. Examples of the hydrocarbon group include an aliphatic hydrocarbon group and an aromatic hydrocarbon group. Examples of the aliphatic hydrocarbon group include an alkyl group having 1 to 20 carbon atoms such as a methyl group, an ethyl group, an n-propyl group, an isopropyl group, an n-butyl group, a sec-butyl group, a tert-butyl group, a pentyl group, a hexyl group, a heptyl group, a 2-ethylhexyl group, an octyl group, a nonyl group, a decyl group, an undecyl group, or a dodecyl group. Among these, an alkyl group having 1 to 12 carbon atoms is preferable.

Examples of the aromatic hydrocarbon group include an aromatic hydrocarbon group having 6 to 20 carbon atoms such as a phenyl group, a naphthyl group, a benzyl group, a tolyl group, or a styryl group.

Examples of the substituent that a monovalent hydrocarbon group may have include a (meth)acryloyl group, a hydroxy group, a sulfanyl group, a carboxy group, an isocyanate group, an amino group, and a ureido group. Further, -CH2- contained in the monovalent hydrocarbon group may be replaced with -O-, -S-, a carbonyl group, or the like.

Here, the photopolymerizable silsesquioxane compound contains three or more polymerizable functional groups. Examples of the polymerizable functional group here include a vinyl group, an allyl group, a methacryloyl group, and an acryloyl group.

The compound represented by the chemical formula: [(RSiO_{3/2})ₙ] may be of a basket type, a ladder type, or a random type. The basket-type silsesquioxane compound may be of a complete basket type or an incomplete basket type in which a part of the basket is open.

Examples of the commercially available product of the photopolymerizable silsesquioxane compound include "MAC-SQ LP-35", "MAC-SQ TM-100", "MAC-SQ SI-20", and "MAC-SQ HDM" (all product names, manufactured by Toagosei Co., Ltd.).

Examples of the polyfunctional monomer containing three or more polymerizable functional groups include a trifunctional monomer such as ethoxylated (3) trimethylolpropane triacrylate, ethoxylated (3) trimethylolpropane trimethacrylate, ethoxylated (6) trimethylolpropane triacrylate, ethoxylated (9) trimethylolpropane triacrylate, ethoxylated (15) trimethylolpropane triacrylate, ethoxylated (20) trimethylolpropane triacrylate, pentaerythritol triacrylate, pentaerythritol trimethacrylate, propoxylated (3) glyceryl triacrylate, propoxylated (3) glyceryl triacrylate, propoxylated (5.5) glyceryl triacrylate, propoxylated (3) trimethylolpropane triacrylate, propoxylated (6) trimethylolpropane triacrylate, trimethylolpropane triacrylate, trimethylolpropane trimethacrylate, tris-(2-hydroxyethyl)-isocyanurate triacrylate, tris-(2-hydroxyethyl)-isocyanurate trimethacrylate, ε-caprolactone-modified tris-(2-acryloxyethyl) isocyanurate, EO-modified trimethylolpropane tri(meth)acrylate, PO-modified trimethylolpropane tri(meth)acrylate, or EO,PO-modified trimethylolpropane tri(meth)acrylate; a tetrafunctional monomer such as ditrimethylolpropane tetraacrylate, ethoxylated (4) pentaerythritol tetraacrylate, or pentaerythritol tetra(meth)acrylate; and a pentafunctional or higher functional monomer such as dipentaerythritol pentaacrylate or dipentaerythritol hexaacrylate.

Examples of the commercially available product of the polyfunctional monomer include "A-9300-1CL", "AD-TMP", "A-9550", and "A-DPH" (all manufactured by Shin-Nakamura Chemical Industry Co., Ltd.), "KAYARAD DPHA" (product name, manufactured by Nippon Kayaku Co., Ltd.), and "Light Acrylate TMP-A" (product name, manufactured by Kyoeisha Chemical Co., Ltd.).

In the photocurable composition according to the embodiment, the component (B) may be used alone or in combination of two or more kinds thereof.

The content of the component (B) is preferably in a range of 0 to 40 parts by mass, more preferably in a range of 3 to 40 parts by mass, and still more preferably in a range of 5 to 35 parts by mass with respect to 100 parts by mass which is the total amount of the component (X), the component (P), and the component (B).

In a case where the content of the component (B) is greater than or equal to the lower limit of the above-described preferable range, the curability and fluidity of the resin cured film formed of the photocurable composition are improved. Further, in a case where the content of the component (B) is less than or equal to the upper limit of the above-described preferable range, the dispersibility of the component (X) in the photocurable composition is improved.

The photocurable composition according to the embodiment may contain a solvent (component (S)).

Specific examples of the component (S) includes alcohols having a chain structure such as methanol, ethanol, n-propyl alcohol, isopropyl alcohol, n-pentyl alcohol, s-pentyl alcohol, t-pentyl alcohol, isopentyl alcohol, 2-methyl-1-propanol, 2-ethylbutanol, neopentyl alcohol, n-butanol, s-butanol, t-butanol, 1-propanol, n-hexanol, 2-heptanol, 3-heptanol, 2-methyl-1-butanol, 2-methyl-2-butanol, 4-methyl-2-pentanol, 1-butoxy-2-propanol, propylene glycol monopropyl ether, 5-methyl-1-hexanol, 6-methyl-2-heptanol, 1-octanol, 2-octanol, 3-octanol, 4-octanol, 2-ethyl-1-hexanol, and 2- (2-butoxyethoxy) ethanol; alcohols having a cyclic structure such as cyclopentanemethanol, 1-cyclopentylethanol, cyclohexanol, cyclohexanemethanol, cyclohexaneethanol, 1,2,3,6-tetrahydrobenzyl alcohol, exo-norborneol, 2-methylcyclohexanol, cycloheptanol, 3,5-dimethylcyclohexanol, benzyl alcohol, and terpineol; and compounds having an ester bond, such as ethylene glycol monoacetate, diethylene glycol monoacetate, propylene glycol monoacetate, and dipropylene glycol monoacetate; derivatives of polyhydric alcohols of compounds having an ether bond such as monoalkyl ether or monophenyl ether, such as monomethylether, monoethylether, monopropylether, or monobutylether of polyhydric alcohols or compounds having an ester bond [among these, propylene glycol monomethyl ether acetate (PGMEA) and propylene glycol monomethyl ether (PGME) are preferable].

In the photocurable composition according to the embodiment, the component (S) may be used alone or in combination of two or more kinds thereof.

These solvents may be used alone or in combination of two or more kinds thereof. Among these, as the component (S), at least one selected from the group consisting of propylene glycol monomethyl ether acetate (PGMEA) and propylene glycol monomethyl ether (PGME) is preferable.

In the photocurable composition according to the present embodiment, it is preferable that the volume average diameter acquired from cumulative volume distribution measured by a dynamic light scattering method (DLS) is 10 nm or greater and 90 nm or less, and the abundance ratio of particles with a particle diameter of 200 nm or greater which is acquired by the dynamic light scattering method (DLS) is 1% or less on a volume basis. In a case where the volume average diameter is in the above-described preferable range and the abundance ratio of particles with a particle diameter of 200 nm or greater is less than or equal to the upper limit of the above-described preferable range, the optical properties (transparency) of the photocurable film formed of the photocurable composition are improved.

The photocurable composition according to the present embodiment described above contains the component (X), the component (P), and the component (C).

In this manner, it is assumed that since the component (P) containing a phosphoric acid group having a high interaction with the metal interface and the component (X) are used in combination, the component (P) is adsorbed on the surface of the component (X), the aggregation of the primary particles of the component (X) is suppressed, and thus the dispersibility of the component (X) in the photocurable composition is improved.

Therefore, according to the photocurable composition of the present embodiment, the optical properties (such as a high refractive index and a haze) of the resin cured film formed of the photocurable composition are excellent.

Such a photocurable composition is useful as a material for forming a fine pattern on a substrate according to an imprint technology, and is particularly suitable for photoimprint lithography. In particular, such a photocurable composition exerts an advantageous effect in applications that require a high refractive index, such as 3D sensors for autonomous driving and AR waveguides for AR (augmented reality) glasses.

Further, the photocurable composition according to the present embodiment is also useful as a material for an antireflection film or the like.

### (Pattern forming method)

A pattern forming method according to a second embodiment of the present invention includes a step of forming a resin film using the photocurable composition according to the first embodiment on a substrate (hereinafter, referred to as a "step (i)"); a step of pressing a mold having an uneven pattern against the resin film to transfer the uneven pattern to the resin film (hereinafter, also referred to as a "step (ii)"; a step of exposing the resin film to which the uneven pattern is transferred while pressing the mold against the resin film to form a resin cured film (hereinafter, also referred to as a "step (iii)"); and a step of peeling the mold off from the resin cured film (hereinafter, also referred to as a "step (iv)").

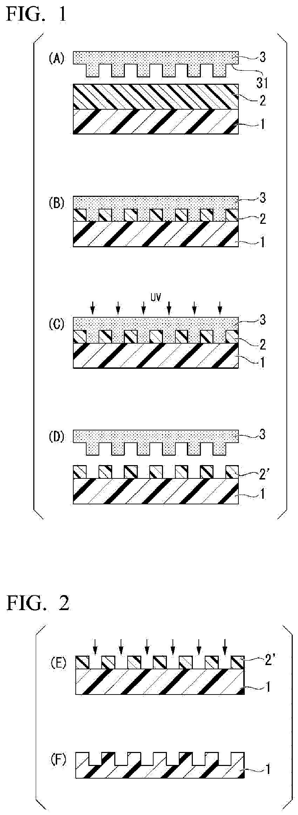

FIGS. 1(A) to 1(D) are schematic step views for describing the embodiment of the pattern forming method.

### [Step (i)]

In the step (i), a resin film is formed on a substrate using the photocurable composition according to the first embodiment described above.

As shown in FIG. 1(A), a substrate 1 is coated with the photocurable composition according to the first embodiment described above to form a resin film 2. In FIG. 1(A), a mold 3 is disposed above the resin film 2.

The substrate 1 can be selected depending on various applications, and examples thereof include a substrate for an electronic component and a substrate on which a predetermined wiring pattern is formed. Specific examples thereof include a substrate made of a metal such as silicon, silicon nitride, copper, chromium, iron, or aluminum; and a glass substrate. Examples of the material of the wiring pattern include copper, aluminum, nickel, and gold.

Further, the shape of the substrate 1 is not particularly limited and may be a plate shape or a roll shape. Further, as the substrate 1, a light-transmitting or non-light-transmitting substrate can be selected depending on the combination with the mold and the like.

Examples of the method of coating the substrate 1 with the photocurable composition include a spin coating method, a spray method, an ink jet method, a roll coating method, and a rotary coating method. Since the resin film 2 functions as a mask of the substrate 1 in an etching step which may be subsequently performed, it is preferable that the resin film 2 has a uniform film thickness in a case of being applied to the substrate 1. From this viewpoint, the spin coating method is suitable in a case where the substrate 1 is coated with the photocurable composition.

The film thickness of the resin film 2 may be appropriately selected depending on the applications thereof, and may be, for example, approximately 0.05 to 30 µm.

### [Step (ii)]

In the step (ii), the mold having an uneven pattern is pressed against the resin film to transfer the uneven pattern to the resin film.

As shown in FIG. 1(B), the mold 3 having a fine uneven pattern on the surface thereof is pressed against the substrate 1, on which the resin film 2 has been formed, so as to face the resin film 2. As a result, the resin film 2 is deformed according to the uneven structure of the mold 3.

The pressure on the resin film 2 during the pressing of the mold 3 is preferably 10 MPa or less, more preferably 5 MPa or less, and particularly preferably 1 MPa or less.

By pressing the mold 3 against the resin film 2, the photocurable composition positioned at projection portions of the mold 3 is easily displaced to the side of recess portions of the mold 3, thus the uneven structure of the mold 3 is transferred to the resin film 2.

The uneven pattern of the mold 3 can be formed according to the desired processing accuracy by, for example, photolithography or an electron beam drawing method.

A light-transmitting mold is preferable as the mold 3. The material of the light-transmitting mold is not particularly limited, but may be any material having predetermined strength and durability. Specific examples thereof include a phototransparent resin film such as glass, quartz, polymethyl methacrylate, or a polycarbonate resin, a transparent metal vapor deposition film, a flexible film such as polydimethylsiloxane, a photocurable film, and a metal film.

### [Step (iii)]

In the step (iii), the resin film to which the uneven pattern is transferred is exposed while the mold is pressed against the resin film to form a resin cured film.

As shown in FIG. 1(C), the resin film 2 to which the uneven pattern is transferred is exposed in a state where the mold 3 is pressed against the resin film 2. Specifically, the resin film 2 is irradiated with electromagnetic waves such as ultraviolet rays (UV). The resin film 2 is cured due to the exposure in the state where the mold 3 is pressed, and thus a resin cured film (resin curing pattern) to which the uneven pattern of the mold 3 has been transferred is formed.

Further, the mold 3 in FIG. 1(C) has a transparency to electromagnetic waves.

The light used to cure the resin film 2 is not particularly limited, and examples thereof include light or radiation having a wavelength in a region such as high-energy ionizing radiation, near ultraviolet rays, far ultraviolet rays, visible rays, or infrared rays. As the radiation, for example, laser light used in fine processing of semiconductors, such as a microwave, EUV, LED, semiconductor laser light, KrF excimer laser light having a wavelength of 248 nm, or an ArF excimer laser having a wavelength of 193 nm can also be suitably used. As the light, monochrome light may be used, or light having a plurality of different wavelengths (mixed light) may be used.

### [Step (iv)]

In the step (iv), the mold is peeled off from the resin cured film.

As shown in FIG. 1(D), the mold 3 is peeled off from the resin cured film. In this manner, a pattern 2' (resin curing pattern) formed of the resin cured film to which the uneven pattern has been transferred is patterned on the substrate 1.

In the pattern forming method according to the present embodiment described above, a photocurable composition containing the component (X), the component (P), and the component (C) is used. Since such a photocurable composition is used, the optical properties (a high refractive index, a haze, and the like) of the formed pattern are improved.

In the present embodiment, a surface 31 of the mold 3 which is brought into contact with the resin film 2 may be coated with a release agent (FIG. 1 (A)). In this manner, the releasability of the mold from the resin cured film can be improved.

Examples of the release agent here include a silicon-based release agent, a fluorine-based release agent, a polyethylene-based release agent, a polypropylene-based release agent, a paraffin-based release agent, a montan-based release agent, and a carnauba-based release agent. Among these, a fluorine-based release agent is preferable. For example, a commercially available coating type release agent such as OPTOOL DSX (manufactured by Daikin Industries, Ltd.) can be suitably used. The release agent may be used alone or in combination of two or more kinds thereof.

Further, in the present embodiment, an organic substance layer may be provided between the substrate 1 and the resin film 2. In this manner, a desired pattern can be easily and reliably formed on the substrate 1 by etching the substrate 1 using the resin film 2 and the organic substance layer as a mask. The film thickness of the organic substance layer may be appropriately adjusted according to the depth at which the substrate 1 is processed (etched). Further, the film thickness thereof is preferably in a range of 0.02 to 2.0 µm. As the material of the organic substance layer, a material which has lower etching resistance to an oxygen-based gas than that of the photocurable composition and has a higher etching resistance to a halogen-based gas than that of the substrate 1 is preferable. The method of forming the organic substance layer is not particularly limited, and examples thereof include a sputtering method and a spin coating method.

The pattern forming method according to the second embodiment may further include other steps (optional steps) in addition to the steps (i) to (iv).

Examples of the optional steps include an etching step (step (v)) and a resin cured film (resin curing pattern) removal step (step (vi)) after the etching treatment.

### [Step (v)]

In the step (v), for example, the substrate 1 is etched using the pattern 2' obtained in the above-described steps (i) to (iv) as a mask.

As shown in FIG. 2 (E), the substrate 1 on which the pattern 2' has been formed is irradiated with at least one of plasma and reactive ion gas (indicated by arrows) so that the portion of the substrate 1 exposed to the side of the pattern 2' is removed by etching to a predetermined depth.

The plasma or reactive ion gas used in the step (v) is not particularly limited as long as the gas is typically used in the dry etching field.

### [Step (vi)]

In the step (vi), the resin cured film remaining after the etching treatment in the step (v) is removed.

As shown in FIG. 2(F), the step (vi) is a step of removing the resin cured film (pattern 2') remaining on the substrate 1 after the etching treatment performed on the substrate 1.

The method of removing the resin cured film (pattern 2') remaining on the substrate 1 is not particularly limited, and examples thereof include a treatment of washing the substrate 1 with a solution in which the resin cured film is dissolved.

### [Examples]

Hereinafter, the present invention will be described in more detail with reference to examples, but the present invention is not limited to these examples.

### <Preparation of photocurable composition>

Each of the photocurable compositions of the examples was prepared by blending the respective components listed in Tables 1 to 4.

**[Table 1]**

| | Component (X) | Component (P) | Component (B) | Component (C) | Component (S) |
|---|---|---|---|---|---|
| | Metal oxide nanoparticles | Phosphoric acid ester | Photopolymerizable monomer | Photopolymerization initiator | Solvent |
| Example 1 | (X)-1 | (P)-1 | (B)-1 | (C)-1 | (S)-1 |
| | [70] | [10] | [20] | [5] | [245] |
| Example 2 | (X)-2 | (P)-1 | (B)-1 | (C)-1 | (S)-2 |
| | [70] | [10] | [20] | [5] | [245] |
| Example 3 | (X)-3 | (P)-1 | (B)-1 | (C)-1 | (S)-2 |
| | [70] | [10] | [20] | [5] | [245] |
| Example 4 | (X)-4 | (P)-1 | (B)-1 | (C)-1 | (S)-2 |
| | [70] | [10] | [20] | [5] | [245] |
| Example 5 | (X)-5 | (P)-1 | (B)-1 | (C)-1 | (S)-2 |
| | [70] | [10] | [20] | [5] | [245] |
| Example 6 | (X)-6 | (P)-1 | (B)-1 | (C)-1 | (S)-1 |
| | [70] | [10] | [20] | [5] | [245] |
| Example 7 | (X)-7 | (P)-1 | (B)-1 | (C)-1 | (S)-1 |
| | [70] | [10] | [20] | [5] | [245] |
| Example 8 | (X)-1 | (P)-1 | (B)-1 | (C)-1 | (S)-1 |
| | [70] | [3] | [27] | [5] | [245] |
| Example 9 | (X)-1 | (P)-1 | (B)-1 | (C)-1 | (S)-1 |
| | [70] | [5] | [25] | [5] | [245] |
| Example 10 | (X)-1 | (P)-1 | (B)-1 | (C)-1 | (S)-1 |
| | [70] | [20] | [10] | [5] | [245] |
| Example 11 | (X)-1 | (P)-1 | - | (C)-1 | (S)-1 |
| | [70] | [30] | | [5] | [245] |
| Example 12 | (X)-1 | (P)-2 | (B)-1 | (C)-1 | (S)-1 |
| | [70] | [10] | [20] | [5] | [245] |
| Example 13 | (X)-1 | (P)-3 | (B)-1 | (C)-1 | (S)-1 |
| | [70] | [10] | [20] | [5] | [245] |
| Example 14 | (X)-1 | (P)-4 | (B)-1 | (C)-1 | (S)-1 |
| | [70] | [10] | [20] | [5] | [245] |
| Example 15 | (X)-1 | (P)-5 | (B)-1 | (C)-1 | (S)-1 |
| | [70] | [10] | [20] | [5] | [245] |
| Example 16 | (X)-1 | (P)-6 | (B)-1 | (C)-1 | (S)-1 |
| | [70] | [10] | [20] | [5] | [245] |

**[Table 2]**

| | Component (X) | Component (P) | Component (B) | Component (C) | Component (S) |
|---|---|---|---|---|---|
| | Metal oxide nanoparticles | Phosphoric acid ester | Photopolymerizable monomer | Photopolymerization initiator | Solvent |
| Example 17 | (X)-1 | (P)-7 | (B)-2 | (C)-1 | (S)-1 |
| | [70] | [3] | [27] | [5] | [245] |
| Example 18 | (X)-1 | (P)-3 | - | (C)-1 | (S)-1 |
| | [70] | [30] | | [5] | [245] |
| Example 19 | (X)-1 | (P)-6 | - | (C)-1 | (S)-1 |
| | [70] | [30] | | [5] | [245] |
| Example 20 | (X)-2 | (P)-3 | (B)-1 | (C)-1 | (S)-2 |
| | [70] | [10] | [20] | [5] | [245] |
| Example 21 | (X)-3 | (P)-3 | (B)-1 | (C)-1 | (S)-2 |
| | [70] | [10] | [20] | [5] | [245] |
| Example 22 | (X)-4 | (P)-3 | (B)-2 | (C)-1 | (S)-2 |
| | [70] | [10] | [20] | [5] | [245] |
| Example 23 | (X)-5 | (P)-3 | (B)-1 | (C)-1 | (S)-2 |
| | [70] | [10] | [20] | [5] | [245] |
| Example 24 | (X)-6 | (P)-3 | (B)-2 | (C)-1 | (S)-1 |
| | [70] | [10] | [20] | [5] | [245] |
| Example 25 | (X)-7 | (P)-3 | (B)-1 | (C)-1 | (S)-1 |
| | [70] | [10] | [20] | [5] | [245] |
| Example 26 | (X)-2 | (P)-7 | (B)-1 | (C)-1 | (S)-2 |
| | [70] | [10] | [20] | [5] | [245] |
| Example 27 | (X)-3 | (P)-7 | (B)-1 | (C)-1 | (S)-2 |
| | [70] | [10] | [20] | [5] | [245] |
| Example 28 | (X)-4 | (P)-7 | (B)-2 | (C)-1 | (S)-2 |
| | [70] | [10] | [20] | [5] | [245] |
| Example 29 | (X)-5 | (P)-7 | (B)-1 | (C)-1 | (S)-2 |
| | [70] | [10] | [20] | [5] | [245] |
| Example 30 | (X)-6 | (P)-7 | (B)-2 | (C)-1 | (S)-1 |
| | [70] | [10] | [20] | [5] | [245] |
| Example 31 | (X)-7 | (P)-7 | (B)-1 | (C)-1 | (S)-1 |
| | [70] | [10] | [20] | [5] | [245] |
| Example 32 | (X)-1 | (P)-1 | (B)-1 | (C)-1 | (S)-1 |
| | [80] | [10] | [10] | [5] | [245] |
| Example 33 | (X)-1 | (P)-1 | (B)-1 | (C)-1 | (S)-1 |
| | [90] | [5] | [5] | [5] | [245] |
| Example 34 | (X)-1 | (P)-1 | (B)-1 | (C)-1 | (S)-1 |
| | [60] | [20] | [20] | [5] | [245] |
| Example 35 | (X)-1 | (P)-1 | (B)-1 | (C)-1 | (S)-1 |
| | [50] | [20] | [30] | [5] | [245] |
| Example 36 | (X)-1 | (P)-1 | (B)-1 | (C)-1 | (S)-1 |
| | [40] | [30] | [30] | [5] | [245] |

**[Table 3]**

| | Component (X) | Component (P) | Component (B) | Component (C) | Component (S) |
|---|---|---|---|---|---|
| | Metal oxide nanoparticles | Phosphoric acid ester | Photopolymerizable monomer | Photopolymerization initiator | Solvent |
| Comparative Example 1 | (X)-1 | - | (B)-1 | (C)-1 | (S)-1 |
| | [70] | | [30] | [5] | [245] |
| Comparative Example 2 | (X)-1 | - | (B)-2 | (C)-1 | (S)-1 |
| | [70] | | [30] | [5] | [245] |
| Comparative Example 3 | (X)-2 | - | (B)-1 | (C)-1 | (S)-2 |
| | [70] | | [30] | [5] | [245] |
| Comparative Example 4 | (X)-3 | - | (B)-1 | (C)-1 | (S)-2 |
| | [70] | | [30] | [5] | [245] |
| Comparative Example 5 | (X)-4 | | (B)-1 | (C)-1 | (S)-2 |
| | [70] | - | [30] | [5] | [245] |
| Comparative Example 6 | (X)-5 | - | (B)-1 | (C)-1 | (S)-2 |
| | [70] | | [30] | [5] | [245] |
| Comparative Example 7 | (X)-6 | - | (B)-1 | (C)-1 | (S)-1 |
| | [70] | | [30] | [5] | [245] |
| Comparative Example 8 | (X)-7 | - | (B)-1 | (C)-1 | (S)-1 |
| | [70] | | [30] | [5] | [245] |
| Comparative Example 9 | (X)-4 | - | (B)-1 | (C)-1 | (S)-2 |
| | [60] | | [40] | [5] | [245] |
| Comparative Example 10 | (X)-4 | - | (B)-1 | (C)-1 | (S)-2 |
| | [40] | | [60] | [5] | [245] |
| Comparative Example 11 | (X)-4 | - | (B)-1 | (C)-1 | (S)-2 |
| | [20] | | [80] | [5] | [245] |

In Tables 1 to 3, each abbreviation has the following meaning. The numerical values in the parentheses are blending amounts (parts by mass).

### · Component (X) (metal oxide nanoparticles)

(X)-1: titania particles, "TITANIA SOL LDB-012" (product name), manufactured by Ishihara Sangyo Kaisha, Ltd., average primary particle diameter of 15 nm
(X)-2: titania particles, "MT-05" (product name), manufactured by Tayca Corporation, average primary particle diameter of 10 nm
(X)-3: titania particles, "MT-100SA" (product name), manufactured by Tayca Corporation, average primary particle diameter of 15 nm
(X)-4: titania particles, "MT-500SA" (product name), manufactured by Tayca Corporation, average primary particle diameter of 35 nm
(X)-5: titania particles, "STR-100A-LP" (product name), manufactured by Sakai Chemical Industry Co., Ltd., average primary particle diameter of 15 nm
(X)-6: zirconia particles, "UEP-50" (product name), manufactured by Daiichi Kisenso Kagaku-Kogyo Co., Ltd., average primary particle diameter of 30 nm
(X)-7: zirconia particles, "UEP-100" (product name), manufactured by Daiichi Kisenso Kagaku-Kogyo Co., Ltd., average primary particle diameter of 15 nm

### · Component (P) (phosphoric acid ester)

(P)-1: 2-methacryloyloxyethyl acid phosphate, "LIGHT ESTER P-1M" (product name), manufactured by Kyoeisha Chemical Co., Ltd., weight-average molecular weight of 228
(P)-2: 2-methacryloyloxyethyl acid phosphate, "LIGHT ESTER P-2M" (product name), manufactured by Kyoeisha Chemical Co., Ltd., weight-average molecular weight of 325
(P)-3: acid phosphoxy methacrylate, "Phosmer M" (product name), manufactured by Unichemical Co., Ltd., weight-average molecular weight of 210
(P)-4: acid phosphoxyethylene glycol monomethacrylate, "Phosmer PE" (product name), manufactured by Unichemical Co., Ltd., weight-average molecular weight of 360
(P)-5: acid phosphoxypropylene glycol monomethacrylate, "Phosmer PP" (product name), manufactured by Unichemical Co., Ltd., weight-average molecular weight of 460
(P)-6: 2-methacryloyloxyethyl caproate acid phosphate, "KAYAMER PM-21" (product name), manufactured by Nippon Kayaku Co., Ltd.
(P)-7: ethyl methacrylate acid phosphate, "KAYAMER PM-2" (product name), manufactured by Nippon Kayaku Co., Ltd., weight-average molecular weight of 322

### · Component (B) (photopolymerizable monomer)

(B)-1: polyfunctional acrylate, "KAYARAD DPHA" (product name", manufactured by Nippon Kayaku Co., Ltd.
(B)-2: trimethylolpropane triacrylate, "LIGHT ACRYLATE TMP-A" (product name), manufactured by Kyoeisha Chemical Co., Ltd.

### · Component (C) (photopolymerization initiator)

(C)-1: 1-hydroxycyclohexylphenyl ketone, "Omnirad 184" (product name), manufactured by IGM Resins B. V.

### · Component (S) (solvent)

(S)-1: propylene glycol monomethyl ether acetate (PGMEA)
(S)-2: propylene glycol monomethyl ether (PGME)

### <Evaluation>

In the photocurable composition of each example, the cumulative volume average particle diameter, the abundance ratio of particles with a particle diameter of 200 nm or greater, the refractive index, the haze, and the imprint filling property were evaluated according to each method described below. The results are listed in Tables 4 to 6.

### [Cumulative volume average particle diameter and abundance ratio of particles with particle diameter of 200 nm or greater]

The volume cumulative average diameter [MV] and the abundance ratio of particles with a particle diameter of 200 nm or greater were measured and analyzed according to the method of acquiring the particle size distribution by performing calculation from the intensity distribution pattern of scattered light using ZetaSizer Nano ZSP (manufactured by Spectris Co., Ltd.).

### [Refractive index]

A silicon substrate was spin-coated by adjusting the rotation speed such that the film thickness reached 1 µm using a spin coater A200 (manufactured by Mikasa Corporation). Next, the substrate was prebaked at 100°C for 2 minutes for solvent volatilization and exposed at 1 J/cm² (in a vacuum atmosphere of 200 Pa) with an imprint device ST-200 (manufactured by Toshiba Machine Co., Ltd.), thereby obtaining a resin cured film.

In regard to the obtained resin cured film, measurement was performed using a spectroscopic ellipsometer M-2000 (manufactured by J. A. Woollam), and fitting was performed thereon using a B-spline function in the wavelength range of 400 nm to 1685 nm to obtain a refractive index at each wavelength. The results of the refractive index at a wavelength of 589 nm are listed in each table.

### [Haze]

An Eagle X glass substrate was spin-coated by adjusting the rotation speed such that the film thickness reached 1 µm using a spin coater A200 (manufactured by Mikasa Corporation). Next, the substrate was prebaked at 100°C for 2 minutes for solvent volatilization and exposed at 1 J/cm² (in a vacuum atmosphere of 200 Pa) with an imprint device ST-200 (manufactured by Toshiba Machine Co., Ltd.), thereby obtaining a resin cured film.

In regard to the obtained resin cured film, the haze was measured under the conditions for measuring the C light source using a spectroscopic color/haze meter COH7700 (manufactured by Nippon Denshoku Industries Co., Ltd.).
A: Less than 0.5
B: 0.5 or greater and less than 1.0
C: 1.0 or greater and less than 5.0
D: 5 or greater

### [Imprint filling property]

A silicon substrate was spin-coated with the photocurable composition such that the film thickness reached 500 nm. Next, the substrate was prebaked at 100°C for 2 minutes, and a transfer test was performed at a transfer pressure of 0.5 MPa and an exposure amount of 1 J/cm² (in a vacuum atmosphere of 200 Pa) for a transfer time of 30 seconds with an imprint device ST-200 (manufactured by Toshiba Machine Co., Ltd.), and the transferability and the filling property of the fine pattern were evaluated based on the following evaluation criteria. A standard film mold LSP70-140 (70 nm Line & Space) (manufactured by Soken Chemical Co., Ltd.) was used as the mold.
A: 95% or greater (in a case of confirmation using an SEM, the mold was filled 100% and the pattern was able to be transferred)
B: Less than 95%

**[Table 4]**

| | Cumulative average particle diameter [nm] | Abundance ratio of particles with particle diameter of 200 nm or greater [%] | Refractive index at wavelength of 589 nm | Haze [%] | Imprint filling property |
|---|---|---|---|---|---|
| Example 1 | 55 | 0 | 1.8 | A | A |
| Example 2 | 48 | 0 | 1.79 | A | A |
| Example 3 | 62 | 0 | 1.8 | A | A |
| Example 4 | 88 | 0 | 1.82 | A | A |
| Example 5 | 59 | 0 | 1.8 | A | A |
| Example 6 | 86 | 0 | 1.75 | A | A |
| Example 7 | 53 | 0 | 1.73 | A | A |
| Example 8 | 67 | 0 | 1.8 | B | A |
| Example 9 | 60 | 0 | 1.8 | A | A |
| Example 10 | 60 | 0 | 1.8 | A | ND |
| Example 11 | 57 | 0 | 1.8 | A | A |
| Example 12 | 85 | 0 | 1.8 | A | ND |
| Example 13 | 54 | 0 | 1.8 | A | ND |
| Example 14 | 79 | 0 | 1.8 | A | ND |
| Example 15 | 87 | 0.8 | 1.8 | B | A |
| Example 16 | 67 | 0.5 | 1.8 | A | ND |

**[Table 5]**

| | Cumulative average particle diameter [nm] | Abundance ratio of particles with particle diameter of 200 nm or greater [%] | Refractive index at wavelength of 589 nm | Haze [%] | Imprint filling property |
|---|---|---|---|---|---|
| Example 17 | 86 | 0.9 | 1.8 | B | A |
| Example 18 | 59 | 0 | 1.8 | A | A |
| Example 19 | 60 | 0 | 1.8 | A | A |
| Example 20 | 50 | 0 | 1.79 | A | ND |
| Example 21 | 61 | 0 | 1.8 | A | ND |
| Example 22 | 84 | 0 | 1.82 | A | ND |
| Example 23 | 55 | 0 | 1.8 | A | ND |
| Example 24 | 88 | 0.7 | 1.75 | B | A |
| Example 25 | 56 | 0 | 1.73 | A | ND |
| Example 26 | 47 | 0 | 1.79 | A | ND |
| Example 27 | 62 | 0 | 1.8 | A | ND |
| Example 28 | 83 | 0.2 | 1.82 | B | A |
| Example 29 | 61 | 0 | 1.8 | A | ND |
| Example 30 | 83 | 0 | 1.75 | A | ND |
| Example 31 | 55 | 0 | 1.73 | A | ND |
| Example 32 | 56 | 0 | 1.87 | A | ND |
| Example 33 | 59 | 0 | 1.94 | A | ND |
| Example 34 | 47 | 0 | 1.74 | A | A |
| Example 35 | 43 | 0 | 1.67 | A | A |
| Example 36 | 41 | 0 | 1.61 | A | A |

**[Table 6]**

| | Cumulative average particle diameter [nm] | Abundance ratio of particles with particle diameter of 200 nm or greater [%] | Refractive index at wavelength of 589 nm | Haze [%] | Imprint filling pproperty |
|---|---|---|---|---|---|
| Comparative Example 1 | 97 | 18.5 | 1.81 | D | B |
| Comparative Example 2 | 95 | 17.9 | 1.8 | D | B |
| Comparative Example 3 | 95 | 15.6 | 1.79 | D | B |
| Comparative Example 4 | 108 | 23.3 | 1.8 | D | B |
| Comparative Example 5 | 156 | 48.3 | Poor coatability Impossible to measure | D | B |
| Comparative Example 6 | 98 | 9.9 | 1.8 | D | B |
| Comparative Example 7 | 142 | 37.9 | Poor coatability Impossible to measure | D | B |
| Comparative Example 8 | 105 | 21 | 1.74 | D | B |
| Comparative Example 9 | 107 | 22.8 | 1.74 | D | B |
| Comparative Example 10 | 96 | 18.1 | 1.6 | D | B |
| Comparative Example 11 | 54 | 0 | 1.56 | D | B |

Based on the results in Tables 4 to 6, it was confirmed that in the photocurable compositions of Examples 1 to 36 to which the present invention had been applied, the volume average diameter acquired from cumulative volume distribution measured by a dynamic light scattering method (DLS) was 10 nm or greater and 90 nm or less and the abundance ratio of particles with a particle diameter of 200 nm or greater which was acquired by the dynamic light scattering method (DLS) was 1% or less on a volume basis.

Further, it was confirmed that the photocurable compositions of Examples 1 to 36 to which the present invention had been applied had satisfactory refractive indices, hazes, and imprint filling properties.

### EXPLANATION OF REFERENCES

1: Substrate
2: Resin film
3: Mold

While preferred embodiments of the invention have been described and illustrated above, it should be understood that these are exemplary of the invention and are not to be considered as limiting. Additions, omissions, substitutions, and other modifications can be made without departing from the scope of the invention. Accordingly, the invention is not to be considered as being limited by the foregoing description, and is only limited by the scope of the appended claims.

## Claims

1. A photocurable composition comprising:
metal oxide nanoparticles having an average primary particle diameter of 50 nm or less as a component (X);
phosphoric acid (meth)acrylate as a component (P); and
a photopolymerization initiator as a component (C).

2. The photocurable composition according to Claim 1,
wherein the component (X) is titania nanoparticles or zirconia nanoparticles.

3. The photocurable composition according to Claim 1 or 2,
wherein a volume average diameter acquired from cumulative volume distribution measured by a dynamic light scattering method (DLS) is 10 nm or greater and 90 nm or less, and
an abundance ratio of particles with a particle diameter of 200 nm or greater which is acquired by the dynamic light scattering method (DLS) is 1% or less on a volume basis.

4. The photocurable composition according to any one of Claims 1 to 3,
wherein a weight-average molecular weight of the component (P) is 300 or less.

5. The photocurable composition according to any one of Claims 1 to 4,
wherein a refractive index of a resin cured film formed of the photocurable composition at a wavelength of 589 nm is 1.7 or greater.

6. The photocurable composition according to any one of Claims 1 to 5,
wherein a ratio of an amount of the component (X) to a total amount of the component (X) and the component (P) is in a range of 0.40 to 0.97.

7. The photocurable composition according to any one of Claims 1 to 6, further comprising:
a photopolymerizable monomer (excluding the component (P)) containing a polymerizable functional group, as a component (B).

8. The photocurable composition according to any one of Claims 1 to 7, further comprising:
a solvent as a component (S).

9. The photocurable composition according to any one of Claims 1 to 8 for use in photoimprint lithography.

10. A pattern forming method comprising:
a step of forming a resin film using the photocurable composition according to any one of Claims 1 to 9 on a substrate;
a step of pressing a mold having an uneven pattern against the resin film to transfer the uneven pattern to the resin film;
a step of exposing the resin film to which the uneven pattern is transferred while pressing the mold against the resin film to form a resin cured film; and
a step of peeling the mold off from the resin cured film.
